# EUROPEAN PATENT APPLICATION

(11) **EP 4 389 504 A1**
(43) Date of publication of application: **26.06.2024**
(21) Application number: 23219282.3
(22) Date of filing: 21.12.2023
(51) Int. Cl.: B60L 53/16, H01R 12/58, H01R 12/73, H01R 13/66, H05K 3/36, H01R 43/20

(54) **CHARGING CONNECTOR AND CHARGING PILE**

(30) Priority: 25.12.2022 CN 202223475279 U
(71) Applicant: Huawei Digital Power Technologies Co., Ltd., Shenzhen, 518043 (CN)
(72) Inventor: LI, Wenkang, Shenzhen, 518043 (CN); YANG, Zezhou, Shenzhen, 518043 (CN)
(74) Representative: Epping - Hermann - Fischer

(57) **Abstract**

Embodiments of this application provide a charging connector for charging an electric vehicle, including a connector body, a connector head, and a terminal connection structure. The connector head is disposed at a front end of the connector body, and the terminal connection structure is disposed in the connector head. The terminal connection structure includes a first PCB, a signal terminal, and a second PCB connected to the first PCB. The first PCB is fixedly connected to a housing of the connector head, and the first PCB is provided with at least one first through hole. One end of the signal terminal is fixedly connected to the first PCB through the at least one first through hole, and the other end of the signal terminal is configured to connect to the electric vehicle, to transmit a signal of the electric vehicle to the first PCB. The second PCB is configured to process the signal from the signal terminal. Based on the charging connector and the terminal connection structure of the charging connector provided in this application, fastening and assembling of terminals of the charging connector can be simplified, and more space is reserved for heat exchange of the connector head of the charging connector.

## Description

### TECHNICAL FIELD

This application relates to the field of new energy vehicle charging, and specifically, to a charging connector and a charging pile.

### BACKGROUND

With development of society and progress of science and technology, new energy vehicles have been favored by an increasing number of consumers, and importance of charging supporting devices related to the new energy vehicles has gradually become prominent. A charging connector is an indispensable device for charging an electric vehicle, and the charging connector is a connection apparatus for transferring electrical energy from a charging pile device to an energy storage battery of the electric vehicle. For a direct-current charging connector, a charging interface of the direct-current charging connector usually includes components such as a signal terminal, an auxiliary power supply terminal, a power terminal, and a ground wire terminal. However, the plurality of terminal components result in a complex connection structure of the charging connector, and affect production and assembling efficiency.

In addition, "charging anxiety" is also one of key problems that restrict the development of the new energy vehicles. Usually, a charging current is increased to improve charging power. However, as the charging current continuously increases, heat generated by the plurality of terminals in the charging connector also continuously increases. Therefore, a heat exchange component usually needs to be added to dissipate heat for components such as a terminal and a cable assembly in the charging connector. Consequently, a higher requirement is also imposed on internal space of a connector head of the charging connector.

In conclusion, how to perform integrated design to reduce complexity of an internal structure of the charging connector is a key path to improve production and assembling efficiency and reduce costs.

### SUMMARY

This application provides a charging connector and a charging pile, so that fastening and assembling of terminals of an existing charging connector can be simplified, and more space is reserved for heat exchange of a connector head of the charging connector.

According to a first aspect, a charging connector for charging an electric vehicle is provided, and includes a connector body, a connector head, and a terminal connection structure. The connector head is disposed at a front end of the connector body, and the terminal connection structure is disposed in the connector head. The terminal connection structure includes: a first PCB, where the first PCB is fixedly connected to a housing of the connector head, and the first PCB is provided with at least one first through hole; a signal terminal, configured to transmit a signal sent by the electric vehicle, where one end of the signal terminal is fixedly connected to the first PCB through the at least one first through hole, and the other end of the signal terminal is configured to connect to the electric vehicle; and a second PCB connected to the first PCB, where the second PCB is configured to process the signal from the signal terminal. According to the technical solution of this application, one end of the signal terminal is fixedly connected to the first PCB through the at least one first through hole, and the other end of the signal terminal is connected to the electric vehicle. The signal from the signal terminal is transmitted to the second PCB through the first PCB, and the second PCB processes the signal from the signal terminal, to implement communication with a charging pile based on the signal. In the foregoing technical solution, a cable connection manner is avoided, so that fastening and assembling of terminals of the charging connector can be simplified, and more space is reserved for heat exchange of the connector head of the charging connector.

With reference to the first aspect, in some implementations of the first aspect, the signal terminal is connected to the first PCB in any one of welding and jack manners through the at least one first through hole.

According to the technical solution of this application, the signal terminal is connected to the first PCB through the at least one first through hole, to avoid using the cable connection manner, so that fastening and assembling of terminals of the charging connector can be simplified, and more space is reserved for heat exchange of the connector head of the charging connector.

With reference to the first aspect, in some implementations of the first aspect, an auxiliary power supply terminal is further included, and is configured to transmit a current signal provided by an auxiliary power supply to the electric vehicle. One end of the auxiliary power supply terminal is connected to the first PCB through at least one second through hole, and the other end of the auxiliary power supply terminal is configured to connect to the electric vehicle. According to the technical solution of this application, one end of the auxiliary power supply terminal is connected to the first PCB through the at least one second through hole, to avoid the cable connection manner, so that fastening and assembling of terminals of the charging connector can be simplified, and more space is reserved for heat exchange of the connector head of the charging connector.

With reference to the first aspect, in some implementations of the first aspect, the auxiliary power supply terminal is connected to the first PCB in any one of welding and jack manners through the at least one second through hole.

According to the technical solution of this application, the auxiliary power supply terminal is connected to the first PCB in the welding or jack manner through the at least one second through hole, so that fastening and assembling of terminals of the charging connector can be simplified, and more space is reserved for heat exchange of the connector head of the charging connector.

With reference to the first aspect, in some implementations of the first aspect, an auxiliary power supply terminal is further included, and is configured to transmit a current signal provided by an auxiliary power supply to the electric vehicle. One end of the auxiliary power supply terminal is fastened to the first PCB through at least one second through hole, and the other end of the auxiliary power supply terminal is configured to connect to the electric vehicle.

In a possible implementation, the second through hole may be set as an unclosed hole, so that the auxiliary power supply terminal is mounted from a bottom of the first PCB.

According to the technical solution of this application, the auxiliary power supply terminal is fixedly connected to the first PCB through the at least one second through hole, so that fastening and assembling of terminals of the charging connector can be simplified.

With reference to the first aspect, in some implementations of the first aspect, a power terminal is further included, and is configured to transmit a charging current signal to the electric vehicle. One end of the power terminal is fastened to the first PCB in a fitting manner through at least one third through hole, and the other end of the power terminal is configured to connect to the electric vehicle.

In a possible implementation, the third through hole may be set as an unclosed hole, so that the power terminal is mounted from a side surface of the first PCB.

According to the technical solution of this application, the power terminal is fixedly connected to the first PCB in the fitting manner through at least one through hole, so that fastening and assembling of terminals of the charging connector can be simplified.

With reference to the first aspect, in some implementations of the first aspect, a ground wire terminal is further included. The ground wire terminal is fastened to the first PCB through at least one fourth through hole.

In a possible implementation, the fourth through hole may be set as an unclosed hole, so that the ground wire terminal is mounted from the bottom of the first PCB.

According to the technical solution of this application, the ground wire terminal is fixedly connected to the first PCB in the fitting manner through at least one through hole, so that fastening and assembling of terminals of the charging connector can be simplified.

With reference to the first aspect, in some implementations of the first aspect, the signal terminal includes a body portion, a fastening portion, and a through hole connection portion that are sequentially arranged in an axial direction of the signal terminal. The through hole connection portion is connected to the first through hole, the fastening portion is provided with a boss, and a diameter of the boss is greater than a diameter of the first through hole. According to the foregoing technical solution, fastening and assembling of terminals of the charging connector can be simplified, and more space is reserved for heat exchange of the connector head of the charging connector.

With reference to the first aspect, in some implementations of the first aspect, the auxiliary power supply terminal includes a body portion, a fastening portion, and a through hole connection portion that are sequentially arranged in an axial direction of the auxiliary power supply terminal. The through hole connection portion is connected to the second through hole, the fastening portion is provided with a boss, and a diameter of the boss is greater than a diameter of the second through hole. According to the foregoing technical solution, fastening and assembling of terminals of the charging connector can be simplified, and more space is reserved for heat exchange of the connector head of the charging connector.

With reference to the first aspect, in some implementations of the first aspect, the auxiliary power supply terminal includes a body portion, a fastening portion, and a cable connection portion that are sequentially arranged in an axial direction of the auxiliary power supply terminal. The cable connection portion is connected to the second through hole, the fastening portion is provided with a boss, and a diameter of the boss is greater than the second through hole. According to the foregoing technical solution, fastening and assembling of terminals of the charging connector can be simplified, and more space is reserved for heat exchange of the connector head of the charging connector.

With reference to the first aspect, in some implementations of the first aspect, the power terminal includes a body portion, a fastening portion, and a cable connection portion that are sequentially arranged in an axial direction of the power terminal. The cable connection portion is connected to the third through hole, the fastening portion is provided with a boss, and a diameter of the boss is greater than the third through hole. According to the foregoing technical solution, fastening and assembling of terminals of the charging connector can be simplified, and more space is reserved for heat exchange of the connector head of the charging connector.

With reference to the first aspect, in some implementations of the first aspect, the ground wire terminal includes a body portion, a fastening portion, and a cable connection portion that are sequentially arranged in an axial direction of the ground wire terminal. The cable connection portion is connected to the fourth through hole, the fastening portion is provided with a boss, and a diameter of the boss is greater than the fourth through hole. According to the foregoing technical solution, fastening and assembling of terminals of the charging connector can be simplified, and more space is reserved for heat exchange of the connector head of the charging connector.

With reference to the first aspect, in some implementations of the first aspect, a sealing ring mounting groove is mounted at one end that is of the fastening portion and that is close to the body portion. According to the foregoing technical solution, fastening and assembling of terminals of the charging connector can be simplified, and more space is reserved for heat exchange of the connector head of the charging connector.

With reference to the first aspect, in some implementations of the first aspect, a sealing ring mounting groove is mounted at one end that is of the fastening portion and that is close to the body portion. According to the foregoing technical solution, fastening and assembling of terminals of the charging connector can be simplified, and more space is reserved for heat exchange of the connector head of the charging connector.

With reference to the first aspect, in some implementations of the first aspect, a sealing ring mounting groove is mounted at one end that is of the fastening portion and that is close to the body portion. According to the foregoing technical solution, fastening and assembling of terminals of the charging connector can be simplified, and more space is reserved for heat exchange of the connector head of the charging connector.

With reference to the first aspect, in some implementations of the first aspect, a sealing ring mounting groove is mounted at one end that is of the fastening portion and that is close to the body portion. According to the foregoing technical solution, fastening and assembling of terminals of the charging connector can be simplified, and more space is reserved for heat exchange of the connector head of the charging connector.

With reference to the first aspect, in some implementations of the first aspect, a PCB mounting groove is mounted at one end that is of the fastening portion and that is close to the cable connection portion. According to the foregoing technical solutions, the terminal can be prevented from rotating in the axial direction, fastening and assembling of terminals of the charging connector are simplified, and more space is reserved for heat exchange of the connector head of the charging connector.

According to a second aspect, a charging pile is provided, and includes a charging pile body and a charging connector. The charging connector is connected to the charging pile body. The charging connector includes a connector body, a connector head, and a terminal connection structure. The connector head is disposed at a front end of the connector body, and the terminal connection structure is disposed in the connector head. The terminal connection structure includes: a first PCB, where the first PCB is fixedly connected to a housing of the connector head, and the first PCB is provided with at least one first through hole; a signal terminal, configured to transmit a signal sent by an electric vehicle, where one end of the signal terminal is fixedly connected to the first PCB through the at least one first through hole, and the other end of the signal terminal is configured to connect to the electric vehicle; and a second PCB connected to the first PCB, where the second PCB is configured to process the signal from the signal terminal. According to the technical solution of this application, one end of the signal terminal is fixedly connected to the first PCB through the at least one first through hole, and the other end of the signal terminal is connected to the electric vehicle. The signal from the signal terminal is transmitted to the second PCB through the first PCB, and the second PCB processes the signal from the signal terminal. In the foregoing technical solution, a cable connection manner is avoided, so that fastening and assembling of terminals of the charging connector can be simplified, and more space is reserved for heat exchange of the connector head of the charging connector.

With reference to the second aspect, in some implementations of the second aspect, the signal terminal is connected to the first PCB in any one of welding and jack manners through the at least one first through hole.

With reference to the second aspect, in some implementations of the second aspect, the charging pile body further includes an auxiliary power supply, and the charging connector further includes an auxiliary power supply terminal. The auxiliary power supply terminal is configured to transmit a current signal provided by the auxiliary power supply to the electric vehicle. One end of the auxiliary power supply terminal is connected to the first PCB through at least one second through hole, and transmits the signal of the auxiliary power supply terminal to the first PCB, and the other end of the auxiliary power supply terminal is configured to connect to the electric vehicle.

With reference to the second aspect, in some implementations of the second aspect, the auxiliary power supply terminal is connected to the first PCB in any one of welding and jack manners through the at least one second through hole.

With reference to the second aspect, in some implementations of the second aspect, the charging pile body further includes an auxiliary power supply, and the charging connector further includes an auxiliary power supply terminal. The auxiliary power supply terminal is configured to transmit a current signal provided by the auxiliary power supply to the electric vehicle. One end of the auxiliary power supply terminal is fastened to the first PCB through at least one second through hole, and the other end of the auxiliary power supply terminal is configured to connect to the electric vehicle.

With reference to the second aspect, in some implementations of the second aspect, the charging pile body further includes a power module, and the charging connector further includes a power terminal. The power terminal is configured to transmit a charging current signal provided by the power module to the electric vehicle. One end of the power terminal is fastened to the first PCB through at least one third through hole, and the other end of the power terminal is configured to connect to the electric vehicle.

With reference to the second aspect, in some implementations of the second aspect, a ground wire terminal is further included. The ground wire terminal is fastened to the first PCB through at least one fourth through hole.

With reference to the second aspect, in some implementations of the second aspect, the signal terminal includes a body portion, a fastening portion, and a through hole connection portion that are sequentially arranged in an axial direction of the signal terminal. The through hole connection portion is connected to the first through hole, the fastening portion is provided with a boss, and a diameter of the boss is greater than a diameter of the first through hole.

With reference to the second aspect, in some implementations of the second aspect, the auxiliary power supply terminal includes a body portion, a fastening portion, and a through hole connection portion that are sequentially arranged in an axial direction of the auxiliary power supply terminal. The through hole connection portion is connected to the second through hole, the fastening portion is provided with a boss, and a diameter of the boss is greater than a diameter of the second through hole.

With reference to the second aspect, in some implementations of the second aspect, the auxiliary power supply terminal includes a body portion, a fastening portion, and a cable connection portion that are sequentially arranged in an axial direction of the auxiliary power supply terminal. The cable connection portion is connected to the second through hole, the fastening portion is provided with a boss, and a diameter of the boss is greater than the second through hole.

With reference to the second aspect, in some implementations of the second aspect, the power terminal includes a body portion, a fastening portion, and a cable connection portion that are sequentially arranged in an axial direction of the power terminal. The cable connection portion is connected to the third through hole, the fastening portion is provided with a boss, and a diameter of the boss is greater than the third through hole.

With reference to the second aspect, in some implementations of the second aspect, the ground wire terminal includes a body portion, a fastening portion, and a cable connection portion that are sequentially arranged in an axial direction of the ground wire terminal. The cable connection portion is connected to the fourth through hole, the fastening portion is provided with a boss, and a diameter of the boss is greater than the fourth through hole.

With reference to the second aspect, in some implementations of the second aspect, a sealing ring mounting groove is mounted at one end that is of the fastening portion and that is close to the body portion.

With reference to the second aspect, in some implementations of the second aspect, a sealing ring mounting groove is mounted at one end that is of the fastening portion and that is close to the body portion.

With reference to the second aspect, in some implementations of the second aspect, a sealing ring mounting groove is mounted at one end that is of the fastening portion and that is close to the body portion.

With reference to the second aspect, in some implementations of the second aspect, a sealing ring mounting groove is mounted at one end that is of the fastening portion and that is close to the body portion.

With reference to the second aspect, in some implementations of the second aspect, a PCB mounting groove is mounted at one end that is of the fastening portion and that is close to the cable connection portion.

### BRIEF DESCRIPTION OF DRAWINGS

FIG. 1 is a schematic diagram of a structure of a charging connector according to an embodiment of this application;
FIG. 2 is a schematic diagram of a terminal connection structure of a charging connector according to an embodiment of this application;
FIG. 3 is a schematic diagram of a terminal connection structure of a charging connector according to another embodiment of this application;
FIG. 4 is a schematic diagram of a terminal connection structure of a charging connector according to another embodiment of this application;
FIG. 5 is a schematic diagram of a terminal connection structure of a charging connector according to another embodiment of this application;
FIG. 6 is a schematic diagram of a terminal connection structure of a charging connector according to another embodiment of this application;
FIG. 7 is a schematic diagram of a structure of a signal terminal according to an embodiment of this application;
FIG. 8 is a schematic diagram of a structure of an auxiliary power supply terminal according to an embodiment of this application;
FIG. 9 is a schematic diagram of a structure of a power terminal according to an embodiment of this application;
FIG. 10 is a schematic diagram of a structure of a ground wire terminal according to an embodiment of this application; and
FIG. 11 is a schematic diagram of a structure of a charging pile according to an embodiment of this application.

### Reference numerals:

100: charging connector; 101: connector body of the charging connector; 102: connector head of the charging connector; 103: handle; 104: lock hook; 105: lock hook button; 106: cable; 110: terminal mounting position; 201: first PCB; 202: inter-PCB connection port; 203: second PCB; 204: screw hole; 301: signal terminal; 3011: first through hole; 401: auxiliary power supply terminal; 4011: second through hole; 501: power terminal; 5011: third through hole; 601: ground wire terminal; 6011: fourth through hole; 710: body portion; 720: fastening portion; 730: through hole connection portion; 7210: boss; 7220: sealing ring mounting groove; 7230: sealing ring; 810: body portion; 820: fastening portion; 830: through hole connection portion; 8210: boss; 8220: sealing ring mounting groove; 8230: sealing ring; 840: cable connection portion; 8250: PCB mounting groove; 910: body portion; 920: fastening portion; 930: cable connection portion; 9210: boss; 9220: sealing ring mounting groove; 9230: sealing ring; 1010: body portion; 1020: fastening portion; 1030: cable connection portion; 1021: boss; 1022: sealing ring mounting groove; 1023: sealing ring; 1024: PCB mounting groove.

### DESCRIPTION OF EMBODIMENTS

The following describes technical solutions of embodiments in this application with reference to the accompanying drawings.

The following describes embodiments of this application in detail. Examples of embodiments of this application are shown in the accompanying drawings. In the accompanying drawings, same or similar reference numerals represent same or similar elements or elements having same or similar functions. The embodiments described below with reference to the accompanying drawings are examples, and are merely used to explain this application, but shall not be understood as a limitation on this application.

In descriptions of this application, it should be noted that, unless otherwise clearly specified and limited, the terms "mounting", "connection to", and "connection" should be understood in a broad sense. For example, the connection may be a fixed connection, may be an indirect connection by using an intermediate medium, or may be an internal connection between two elements or an interaction relationship between two elements. A person of ordinary skill in the art may interpret specific meanings of the foregoing terms in this application according to specific cases.

It should be noted that a terminal connection structure of a charging connector provided in embodiments of this application may be used in a charging connector. The charging connector may be a naturally cooled charging connector, a liquid-cooled charging connector, a charging pile, or the like. This is not limited in this application.

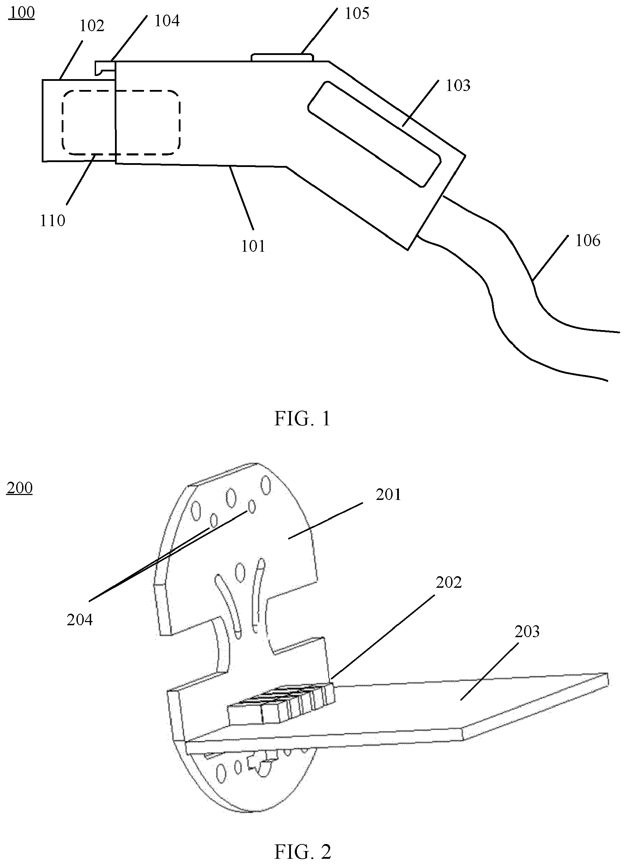

FIG. 1 is a schematic diagram of a structure of a charging connector 100 according to this application.

As shown in FIG. 1, the charging connector 100 includes a connector body 101, a connector head 102 disposed at a front end of the connector body 101, and a handle 103 disposed at the other end of the connector body 101. The handle 103 is connected to the connector body 101 at a specific angle in an inclined manner. A lock hook 104 for locking the charging connector 100 is disposed on one side of the connector body 101, and a lock hook button 105 is disposed on the other side that is of the connector body 101 and that is close to the handle 103. The lock hook button 105 is configured to control locking or unlocking of the charging connector 100. A cable 106 is connected to a rear end of the connector body 101. The cable 106 is configured to connect a charging pile (not shown in the figure) and the charging connector 100, so that the charging pile charges the charging connector 100. It should be noted that a terminal connection structure 200 provided in this application is used in a terminal mounting position 110 in FIG. 1 (for example, an area in a dashed box in FIG. 1).

Currently, a method for connecting a charging connector terminal to a cable is usually used. Specifically, each charging connector terminal corresponds to one cable, and a terminal is connected to a signal cable in a crimping or welding manner. In addition, each terminal is fastened to a housing of the charging connector by using a fastening clamping seat.

Each terminal needs to be connected to a cable. As a result, problems such as a complex cable connection and low assembling automation occur on each terminal of the entire charging connector. In addition, the fastening clamping seat is used to fasten each terminal to the housing of the charging connector. Due to a fact that space occupied by the fastening clamping seat is large, mounting of another heat dissipation component is not facilitated, and heat dissipation cannot be better performed on each terminal of the charging connector as well as a component such as a cable assembly. In conclusion, how to simplify fastening and assembling of terminals of the charging connector and reserve more space for heat exchange of the connector head of the charging connector becomes an urgent problem to be resolved. Embodiments of this application provide a charging connector and a terminal connection structure of the charging connector, so that fastening and assembling of terminals of the existing charging connector can be simplified, and more space is reserved for heat exchange of a connector head of the charging connector.

FIG. 2 is a schematic diagram of a terminal connection structure 200 in a charging connector according to an embodiment of this application.

FIG. 2 shows the terminal connection structure 200. The terminal connection structure 200 is disposed in the connector head 102. The terminal connection structure 200 may include a first PCB 201 and a second PCB 203. The first PCB 201 is fixedly connected to a housing (not shown in the figure) of the connector head 102 through screw holes 204, and is connected to the second PCB 203 through an inter-PCB connection port 202.

The first PCB 201 mainly transmits a signal of each terminal to the second PCB 203 through the inter-PCB connection port 202, and serves as a fastening support to provide limiting and fastening functions for each terminal. An integrated processor is disposed on the second PCB 203. The second PCB 203 mainly processes signals from a signal terminal and a sensor, and implements communication with a charging pile (not shown in the figure) based on the signals from the signal terminal and the sensor.

It should be noted that the first PCB 201 and the second PCB 203 may be connected through a pin terminal, or may be connected through a flexible cable. It should be understood that this is not limited in this embodiment of this application.

It should be further noted that, when the first PCB 201 is connected to the second PCB 203 through the pin terminal, the first PCB 201 and the second PCB 203 are vertically connected. As shown in FIG. 2, the first PCB 201 and the second PCB 203 are connected at a vertical angle. However, when the first PCB 201 is connected to the second PCB 203 through the flexible cable, the first PCB 201 and the second PCB 203 are fixedly connected at any angle. It should be understood that this is not limited in this embodiment of this application.

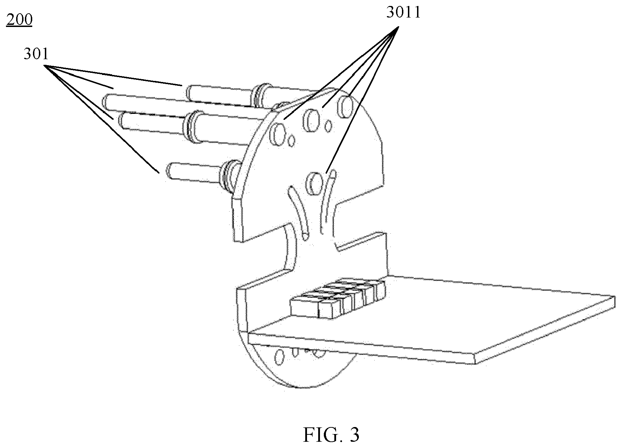

FIG. 3 is a schematic diagram of a terminal connection structure according to another embodiment of this application. As shown in FIG. 3, the charging connector 100 includes the first PCB 201, a signal terminal 301, and the second PCB 203. The first PCB 201 is fixedly connected to the housing of the connector head 102 through the screw holes 204, and the first PCB 201 is provided with at least one first through hole 3011.

Specifically, one end of the signal terminal is fixedly connected to the first PCB 201 through the at least one first through hole 3011, and the other end of the signal terminal 301 is configured to connect to an electric vehicle. For example, the other end of the signal terminal 301 may be connected to a socket (not shown in the figure) on the electric vehicle, and the signal terminal is configured to transmit a signal of the electric vehicle to the first PCB 201. In this case, the first PCB 201 transmits the signal from the signal terminal 301 to the second PCB 203 through an inter-PCB connection port 202, and the second PCB 203 processes the signal from the signal terminal 301 by using an integrated processor, and communicates with a charging pile (not shown in the figure) based on the signal.

The signal from the signal terminal 301 may be used to determine whether the charging connector is connected to a charging port on the electric vehicle in place, or the signal from the signal terminal 301 may be communication information between the charging pile and the signal terminal 301. For example, the charging pile sends identification information to a vehicle system of the electric vehicle by using the signal terminal 301, and then the vehicle system of the electric vehicle sends vehicle information to the charging pile by using the signal terminal 301.

Optionally, in some embodiments, the signal terminal 301 may be connected to the first PCB 201 in a welding manner through the first through hole 3011. The welding manner includes but is not limited to submerged arc welding, arc welding, argon arc welding, and the like. It should be understood that this is not limited in this embodiment of this application.

Optionally, in some embodiments, the signal terminal 301 may alternatively be connected to the first PCB 201 in a jack interference fit manner through the first through hole 3011. The jack may be a copper jack, or may be made of another conductive metal material. It should be understood that this is not limited in this embodiment of this application.

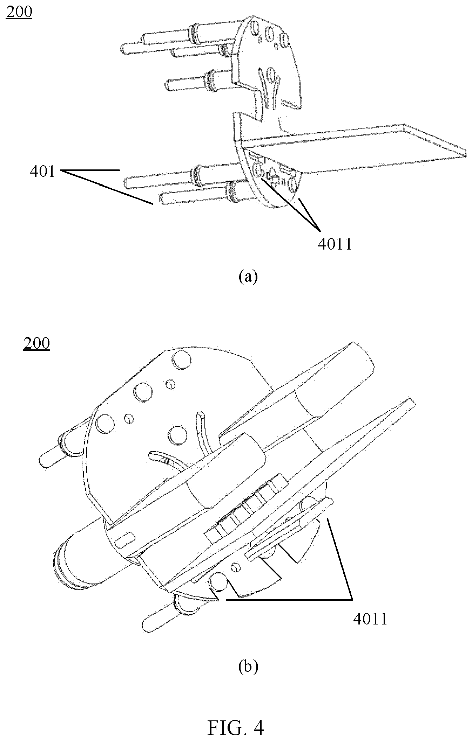

FIG. 4 is a schematic diagram of a terminal connection structure 200 according to another embodiment of this application.

Optionally, in some embodiments, as shown in (a) in FIG. 4, the charging connector 100 further includes an auxiliary power supply terminal 401, and the first PCB 201 is further provided with at least one second through hole 4011. The first PCB 201 is fixedly connected to the housing of the connector head 102 through the screw holes 204, and is connected to the second PCB 203 through the inter-PCB connection port 202.

Specifically, one end of the auxiliary power supply terminal 401 is fixedly connected to the first PCB 201 through the at least one second through hole 4011, and the other end of the auxiliary power supply terminal 401 is configured to connect to the electric vehicle. In other words, the other end of the auxiliary power supply terminal 401 is connected to a charging port on the electric vehicle, and the auxiliary power supply terminal is configured to transmit a current signal provided by an auxiliary power supply in the charging pile to the electric vehicle.

One end of the auxiliary power supply terminal 401 is fixedly connected to the first PCB 201, the first PCB 201 is connected to the second PCB 203 through the inter-PCB connection port 202. One end of the second PCB 203 is crimped with a cable (not shown in the figure), and is connected to the charging pile through the cable. In this case, the current signal of the auxiliary power supply in the charging pile is transmitted to the second PCB 203 through the cable, and then the current signal is transmitted to the first PCB 201 and the auxiliary power supply terminal 401. For example, the auxiliary power supply terminal 401 wakes up a vehicle control unit (vehicle control unit, VCU) through the charging port. In addition, when the charging pile charges the electric vehicle by using the charging connector, the auxiliary power supply in the charging pile provides the current signal to the auxiliary power supply terminal 401, and then the auxiliary power supply terminal 401 provides the current signal provided by the auxiliary power supply in the charging pile to the charging port of the electric vehicle, to charge a battery management system (battery management system, BMS) and the VCU in the vehicle.

Optionally, in some embodiments, one end of the auxiliary power supply terminal 401 may be connected to the first PCB 201 in a welding manner through the at least one second through hole 4011. The welding manner includes but is not limited to submerged arc welding, arc welding, argon arc welding, and the like. It should be understood that this is not limited in this embodiment of this application.

Optionally, in some embodiments, one end of the auxiliary power supply terminal 401 is fixedly connected to the first PCB 201 through the second through hole 4011, or may be fixedly connected to the first PCB 201 in a jack interference fit manner. The jack may be a copper jack, or may be made of another conductive metal material. It should be understood that this is not limited in this embodiment of this application.

Optionally, in some embodiments, in the terminal connection structure 200, the auxiliary power supply terminal 401 may alternatively be fixedly connected to the first PCB 201 in a fitting manner through the second through hole 4011, the other end of the auxiliary power supply terminal 401 is connected to the charging port on the electric vehicle. The auxiliary power supply terminal 401 is configured to transmit the current signal provided by the auxiliary power supply in the charging pile to the electric vehicle.

When the auxiliary power supply terminal 401 is fixedly connected to the first PCB 201 in the fitting manner, a cable is further crimped at one end that is of the auxiliary power supply terminal and that is connected to the first PCB. The cable is configured to connect to the charging pile. In this case, the auxiliary power supply in the charging pile provides the current signal to the auxiliary power supply terminal 401 through the cable.

It should be understood that the second through hole 4011 may be an unclosed hole. As shown in (b) in FIG. 4, the second through hole 4011 may be an unclosed hole at a bottom. Such a design facilitates mounting of the auxiliary power supply terminal 401 from the bottom.

It should be understood that, the second through hole 4011 may alternatively be a hole with an internal thread structure. Correspondingly, one end that is of the auxiliary power supply terminal 401 and that is close to the first PCB 201 is provided with an external thread structure matching the internal thread structure, so that the auxiliary power supply terminal 401 is tightly fit with the first PCB 201 through the second through hole 4011.

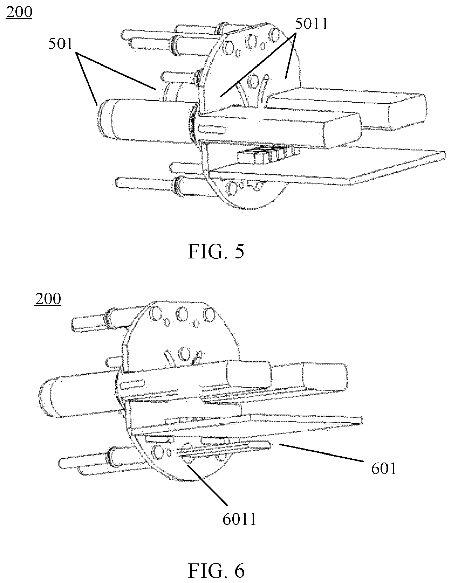

FIG. 5 is a schematic diagram of a terminal connection structure 200 according to another embodiment of this application. As shown in FIG. 5, the charging connector 100 further includes a power terminal 501. One end of the power terminal 501 is fixedly connected to the first PCB 201 in a fitting manner through at least one third through hole 5011, and the other end of the power terminal 501 is connected to the electric vehicle. The power terminal 501 is configured to transmit a charging current signal to the electric vehicle. In other words, the power terminal 501 is configured to provide a high-power charging current to a charging port on the electric vehicle, to fast charge the electric vehicle.

It should be understood that the third through hole 5011 may be an unclosed hole. As shown in FIG. 5, the third through hole 5011 may be an unclosed hole on a side surface. Such a design facilitates mounting of the power terminal 501 from the side surface.

It should be understood that, the third through hole 5011 may alternatively be a hole with an internal thread structure. Correspondingly, one end that is of the power terminal 501 and that is close to the first PCB 201 is provided with an external thread structure matching the internal thread structure, so that the power terminal 501 is tightly fit with the first PCB 201 through the third through hole 5011.

FIG. 6 is a schematic diagram of a terminal connection structure 200 according to another embodiment of this application. As shown in FIG. 6, the charging connector 100 further includes a ground wire terminal 601. The ground wire terminal 601 is fixedly connected to the first PCB 201 in a fitting manner through a fourth through hole 6011, and the other end of the ground wire terminal 601 is connected to the electric vehicle. The ground wire terminal 601 is mainly used for protection, to avoid a non-safety accident when the charging pile charges the electric vehicle by using the charging connector.

It should be understood that, the fourth through hole 6011 may alternatively be a hole with an internal thread structure. Correspondingly, one end that is of the ground wire terminal 601 and that is close to the first PCB 201 is provided with an external thread structure matching the internal thread structure, so that the ground wire terminal 601 is tightly fit with the first PCB 201 through the fourth through hole 6011.

It should be understood that the fourth through hole 6011 may be an unclosed hole. As shown in (b) in FIG. 4, the fourth through hole 6011 may be an unclosed hole at a bottom. Such a design facilitates mounting of the ground wire terminal 601 from the bottom.

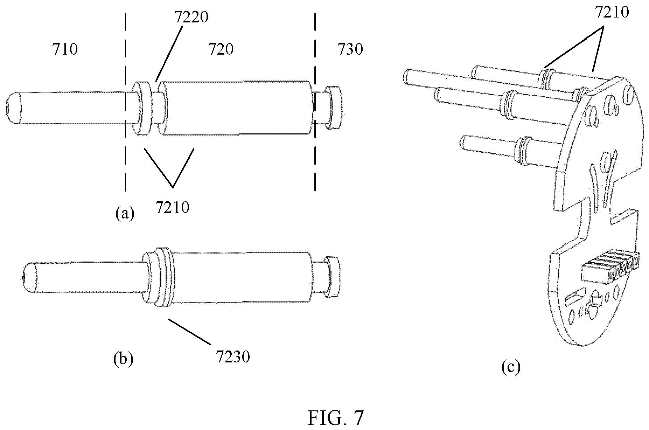

The foregoing describes in detail the charging connector and the terminal connection structure of the charging connector with reference to FIG. 2 to FIG. 6. The following describes in detail schematic diagrams of structures of each charging connector terminal in this application with reference to FIG. 7 to FIG. 10.

FIG. 7 is a schematic diagram of a structure of a signal terminal according to an embodiment of this application. As shown in (a) in FIG. 7, the signal terminal 301 is sequentially arranged with a body portion 710, a fastening portion 720, and a through hole connection portion 730 in an axial direction thereof. The body portion 710 of the signal terminal 301 is tightly connected to the housing of the connector head 102, and the fastening portion 720 of the signal terminal 301 is provided with a boss 7210. As shown in (c) in FIG. 7, the through hole connection portion 730 of the signal terminal 301 is fixedly connected to the first PCB 201 in a welding or jack manner through the first through hole 3011. To enable the signal terminal 301 to be tightly fastened to the first PCB 201, a diameter of the boss 7210 is usually set to be greater than a diameter of the first through hole 3011.

It should be noted that, as shown in (a) in FIG. 7 and (b) in FIG. 7, a sealing ring mounting groove 7220 is mounted at one end that is of the fastening portion 720 of the signal terminal 301 and that is close to the body portion 710. The sealing ring mounting groove 7220 is configured to mount a sealing ring 7230, so that the signal terminal 301 is tightly connected to the first through hole 3011, to prevent the signal terminal 301 from rotating in an axial direction.

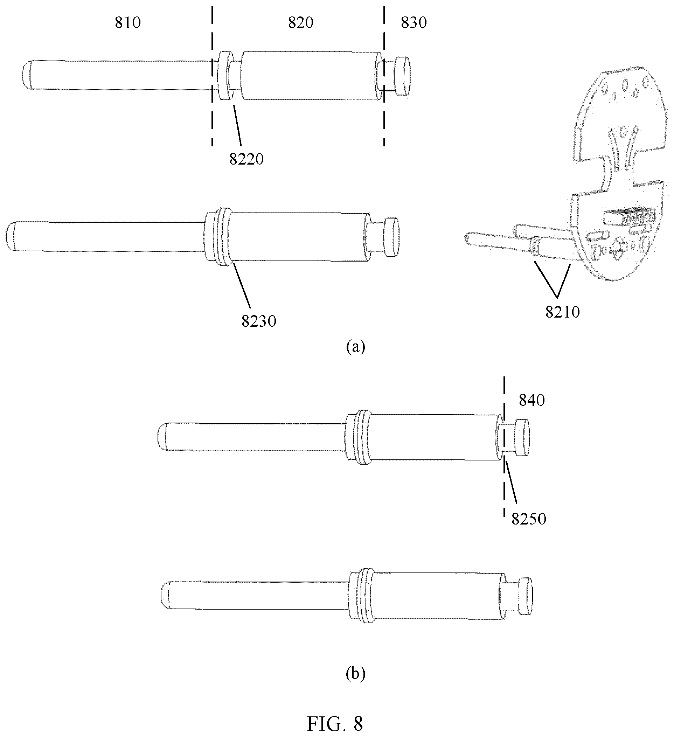

FIG. 8 is a schematic diagram of a structure of an auxiliary power supply terminal according to an embodiment of this application. As shown in (a) in FIG. 8, the auxiliary power supply terminal 401 is connected to the first PCB 201 in a welding or jack manner. A specific connection manner is described above. For brevity, details are not described again. Specifically, the auxiliary power supply terminal 401 is sequentially arranged with a body portion 810, a fastening portion 820, and a through hole connection portion 830 in an axial direction thereof. The body portion 810 of the auxiliary power supply terminal 401 is tightly connected to the housing of the connector head 102. The fastening portion 820 of the auxiliary power supply terminal 401 is provided with a boss 8210. The through hole connection portion 830 of the auxiliary power supply terminal and the second through hole 4011 are fixedly connected to the first PCB 201 in a welding or jack manner. To enable the auxiliary power supply terminal 401 to be tightly fastened to the first PCB 201, a diameter of the boss 8210 is usually set to be greater than a diameter of the second through hole 4011. It should be noted that a sealing ring mounting groove 8220 is mounted at one end that is of the fastening portion 820 of the auxiliary power supply terminal 401 and that is close to the body portion 810. The sealing ring mounting groove 8220 is configured to mount a sealing ring 8230, so that the auxiliary power supply terminal 401 is tightly connected to the second through hole 4011, to prevent the auxiliary power supply terminal 401 from rotating in an axial direction. Optionally, in some embodiments, as shown in (b) in FIG. 4, the auxiliary power supply terminal 401 may alternatively be connected to the first PCB 201 in a fitting manner through the second through hole 4011. It should be understood that, for a specific fitting manner, refer to the foregoing description. Details are not described herein again in this application.

As shown in (b) in FIG. 8, the auxiliary power supply terminal 401 is sequentially arranged with a body portion 810, a fastening portion 820, and a cable connection portion 840 in an axial direction thereof. The body portion 810 of the auxiliary power supply terminal 401 is tightly connected to the housing of the connector head 102. The fastening portion 820 of the auxiliary power supply terminal 401 is provided with a boss 8210. The cable connection portion 840 of the auxiliary power supply terminal is fixedly connected to the first PCB 201 in a fitting manner through the second through hole 4011, and is connected to the cable connected to the charging pile.

Optionally, in some embodiments, a PCB mounting groove 8250 is mounted at one end that is of the fastening portion 820 of the auxiliary power supply terminal 401 and that is close to the cable connection portion 440. The PCB mounting groove 8250 may be of a circular or non-circular structure. For example, the PCB mounting groove 8250 may be of a cylindrical structure shown in (b) in FIG. 8, or may be of a square structure shown in (b) in FIG. 8. A function of the PCB mounting groove is to prevent the auxiliary power supply terminal 401 from rotating in an axial direction in a process of using the charging connector.

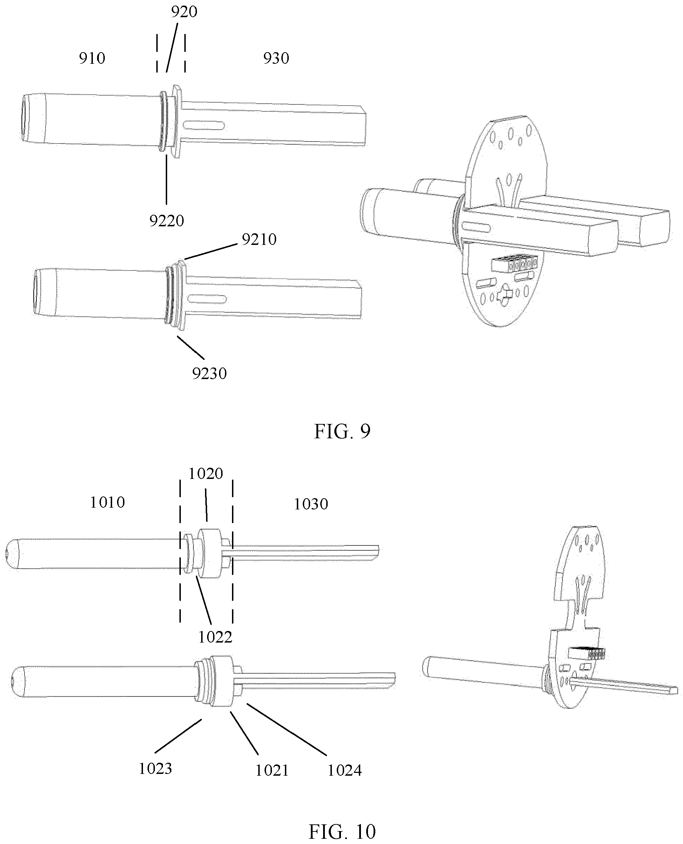

FIG. 9 is a schematic diagram of a structure of a power terminal according to an embodiment of this application. As shown in FIG. 9, the power terminal 501 is sequentially arranged with a body portion 910, a fastening portion 920, and a cable connection portion 930 in an axial direction thereof. The body portion 910 of the power terminal 501 is tightly connected to the housing of the connector head 102. The fastening portion 920 of the power terminal 501 is provided with a boss 9210. The cable connection portion 930 of the power terminal 501 is connected to the first PCB 201 in a fitting manner through the third through hole 5011, and is connected to the cable connected to the charging pile. To enable the power terminal 501 to be tightly fastened to the first PCB 201, a diameter of the boss 9210 is usually set to be greater than the third through hole 5011.

Optionally, in some embodiments, a sealing ring mounting groove 9220 is mounted at one end that is of the fastening portion 920 of the power terminal 501 and that is close to the body portion 910. The sealing ring mounting groove 9220 is configured to mount a sealing ring 9230, so that the power terminal 501 is tightly connected to the first PCB 201 through the third through hole 5011, to prevent the power terminal 501 from rotating in an axial direction. Optionally, in some embodiments, a PCB mounting groove 9240 is mounted at one end that is of the fastening portion 920 of the power terminal 501 and that is close to the cable connection portion 930. As shown in the figure, the PCB mounting groove 9240 may be of a non-circular structure, to prevent the power terminal 501 from rotating in an axial direction in a process of using the charging connector.

FIG. 10 is a schematic diagram of a structure of a ground wire terminal according to an embodiment of this application. As shown in FIG. 10, the ground wire terminal 601 is sequentially arranged with a body portion 1010, a fastening portion 1020, and a cable connection portion 1030 in an axial direction thereof. The body portion 1010 of the ground wire terminal 601 is tightly connected to the housing of the connector head 102. The fastening portion 1020 of the ground wire terminal 601 is provided with a boss 1021. The cable connection portion 1030 of the ground wire terminal 601 is connected to the first PCB 201 in a fitting manner through the fourth through hole 6011, and is connected to the cable of the charging pile. To enable the ground wire terminal 601 to be tightly fastened to the first PCB 201, a diameter of the boss 1021 is usually set to be greater than the fourth through hole 6011.

Optionally, in some embodiments, a sealing ring mounting groove 1022 is mounted at one end that is of the fastening portion 1020 of the ground wire terminal 601 and that is close to the body portion 1010 of the ground wire terminal 601. The sealing ring mounting groove 1022 is configured to mount a sealing ring 1023, so that the ground wire terminal 601 is tightly connected to the first PCB 201 through the fourth through hole 6011, to prevent the ground wire terminal 601 from rotating in an axial direction.

Optionally, in some embodiments, a PCB mounting groove 1024 is mounted at one end that is of the fastening portion 1020 of the ground wire terminal 601 and that is close to the cable connection portion 1030. As shown in the figure, the PCB mounting groove 1024 may be of a non-circular structure, to prevent the ground wire terminal 601 from rotating in an axial direction in a process of using the charging connector.

It should be noted that the PCB mounting groove described above may be of a rectangular structure, a triangular structure, or a diamond structure. It should be understood that this is not limited in this embodiment of this application.

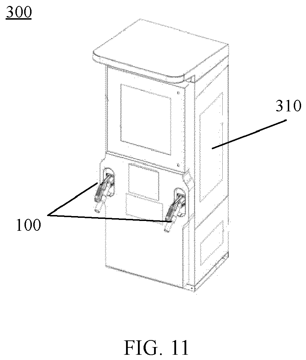

FIG. 11 is a schematic diagram of a structure of a charging pile according to an embodiment of this application.

As shown in FIG. 11, a charging pile 300 includes a charging pile body 310 and a charging connector 100. The charging connector 100 is connected to the charging pile body 310. In other words, one end of the charging connector 100 is connected to the charging pile 310 through a connection cable (not shown in the figure).

It should be noted that, for a specific structure of the charging connector 100 shown in FIG. 11, refer to the charging connector and the terminal connection structure of the charging connector described above. Details are not described in this embodiment of this application.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A charging connector for charging an electric vehicle, comprising a connector body (101), a connector head (102), and a terminal connection structure (200), wherein
the connector head (102) is disposed at a front end of the connector body (101), and the terminal connection structure (200) is disposed in the connector head (102); and
the terminal connection structure (200) comprises:
a first PCB (201), wherein the first PCB (201) is fixedly connected to a housing of the connector head (102), and the first PCB (201) is provided with at least one first through hole (3011);
a signal terminal (301), configured to transmit a signal sent by the electric vehicle, wherein one end of the signal terminal (301) is fixedly connected to the first PCB (201) through the at least one first through hole (3011), and the other end of the signal terminal (301) is configured to connect to the electric vehicle; and
a second PCB (203) connected to the first PCB (201), wherein the second PCB (203) is configured to process the signal from the signal terminal (301).

2. The charging connector according to claim 1, wherein the first PCB (201) is provided with at least one second through hole (4011), and the charging connector further comprises:
an auxiliary power supply terminal (401), configured to transmit a current signal provided by an auxiliary power supply to the electric vehicle, wherein one end of the auxiliary power supply terminal (401) is connected to the first PCB (201) through the at least one second through hole (4011), and the other end of the auxiliary power supply terminal (401) is configured to connect to the electric vehicle.

3. The charging connector according to claim 1 or 2, wherein the first PCB (201) is provided with at least one third through hole (5011), and the charging connector further comprises:
a power terminal (501), configured to transmit a charging current signal to the electric vehicle, wherein one end of the power terminal (501) is fastened to the first PCB (201) through the at least one third through hole (5011), and the other end of the power terminal (501) is configured to connect to the electric vehicle.

4. The charging connector according to any one of claims 1 to 3, wherein the first PCB (201) is provided with at least one fourth through hole (6011), and the charging connector further comprises:
a ground wire terminal (601), wherein the ground wire terminal (601) is fastened to the first PCB (201) through the at least one fourth through hole (6011).

5. A charging pile for charging an electric vehicle, comprising a charging pile body (310) and a charging connector (100), wherein the charging connector (100) is connected to the charging pile body (310), the charging connector (100) comprises a connector body (101), a connector head (102), and a terminal connection structure (200), the connector head (102) is disposed at a front end of the connector body (101), and the terminal connection structure (200) is disposed in the connector head (102); and
the terminal connection structure (200) comprises:
a first PCB (201), wherein the first PCB (201) is fixedly connected to a housing of the connector head (102), and the first PCB (201) is provided with at least one first through hole (3011);
a signal terminal (301), configured to transmit a signal sent by the electric vehicle, wherein one end of the signal terminal (301) is fixedly connected to the first PCB (201) through the at least one first through hole (3011), and the other end of the signal terminal (301) is configured to connect to the electric vehicle; and
a second PCB (203) connected to the first PCB (201), wherein the second PCB (203) processes the signal from the signal terminal (301).

6. The charging pile according to claim 5, wherein the first PCB (201) is provided with at least one second through hole (4011), the charging pile body (310) further comprises an auxiliary power supply, and the charging connector (100) further comprises an auxiliary power supply terminal (401), wherein
the auxiliary power supply terminal (401) is configured to transmit a current signal provided by the auxiliary power supply to the electric vehicle, one end of the auxiliary power supply terminal (401) is connected to the first PCB (201) through the at least one second through hole (4011), and the other end of the auxiliary power supply terminal (401) is configured to connect to the electric vehicle.

7. The charging pile according to claim 5 or 6, wherein the first PCB (201) is provided with at least one third through hole (5011), the charging pile body (310) further comprises a power module, and the charging connector (100) further comprises a power terminal (501), wherein
the power terminal (501) is configured to transmit a charging current signal provided by the power module to the electric vehicle, one end of the power terminal (501) is fastened to the first PCB (201) through the at least one third through hole (5011), and the other end of the power terminal (501) is configured to connect to the electric vehicle.

8. The charging pile according to any one of claims 5 to 7, wherein the first PCB (201) is provided with at least one fourth through hole (6011), and the charging connector (100) further comprises a ground wire terminal (601), wherein
the ground wire terminal (601) is fastened to the first PCB (201) through the at least one fourth through hole (6011).
